(19) Europäisches Patentamt
European Patent Office
Office européen des brevets

(11) **EP 1 346 947 A2**

(12) **EUROPEAN PATENT APPLICATION**

(43) Date of publication:
24.09.2003 Bulletin 2003/39

(51) Int Cl.$^7$: **B81B 3/00**, B81B 7/02,
G02B 6/35, G02B 6/26,
G02B 26/08, H01G 5/00

(21) Application number: 03006169.1

(22) Date of filing: 19.03.2003

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK RO**

(30) Priority: 19.03.2002 JP 2002075817

(71) Applicant: **JAPAN AVIATION
ELECTRONICS INDUSTRY, LIMITED
Shibuya-ku, Tokyo 150-0043 (JP)**

(72) Inventor: **Norimatsu, Toshihide,
Japan Electronics Indust.Ltd
Tokyo 150-0043 (JP)**

(74) Representative: **Hoffmann, Eckart, Dipl.-Ing. et al
Patentanwalt,
Bahnhofstrasse 103
82166 Gräfelfing (DE)**

(54) **Electrostatically operated optical switching or attenuating devices**

(57) In an electrostatically operated device in which on the bottom surface side and the top surface side of a movable plate-like electrode are disposed a stationary electrode substrate (8) and a second stationary plate-like electrode (40) substantially in parallel with the movable plate-like electrode (2), the movable plate-like electrode is maintained at a position that is away by a first predetermined distance from the stationary electrode substrate and by a second predetermined distance from the second stationary plate-like electrode when any drive voltage is not applied to the second stationary plate-like electrode and to the stationary electrode substrate. In operation, a drive voltage more than or less than the pull-in voltage is applied to the second stationary plate-like electrode or the stationary electrode substrate, thereby to drive electrostatically the movable plate-like electrode toward the second stationary plate-like electrode or the stationary electrode substrate.

# FIG. 12

# FIG. 16A

**Description**

BACKGROUND OF THE INVENTION

1. Field of the Invention

The present invention relates to an electrostatically operated device that is manufactured by use of micromachining technology, and more particularly, to an electrostatically operated device that is capable of greatly reducing the magnitude of a drive voltage applied between a movable plate-like electrode and a stationary or fixed electrode substrate of the device.

2. Description of the Related Art

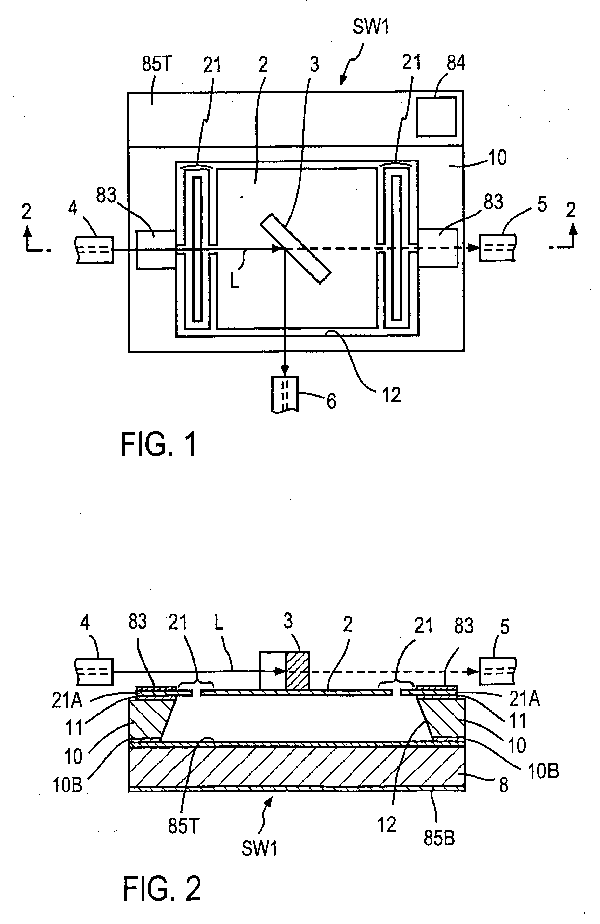

An electrostatically operated device that is manufactured by use of micromachining technology can be embodied, for example, as an optical switch for changing the path of an optical signal propagating through an optical waveguide such as an optical fiber. For clarity of explanation, a case in which an electrostatically operated device is embodied as an optical switch will be described hereinafter.
At first, an example of the prior art optical switch will be briefly described with reference to Figs. 1 and 2. Fig. 1 is a plan view illustrating a construction of the prior art optical switch, and Fig. 2 is a sectional view taken along the line 2-2 in Fig. 1 and looking in the direction indicated by the arrows. The illustrated switch SW1 comprises: a stationary electrode substrate 8 of a generally rectangle in plan; a movable electrode supporting frame 10 of a generally rectangle in plan, the major side thereof having substantially the same length as that of the stationary electrode substrate 8 and the minor side thereof being shorter than that of the stationary electrode substrate 8; a movable plate-like electrode 2 of a generally square in plan that is disposed substantially in parallel with the stationary electrode substrate 8 with a space or gap between them and above the central portion of an opening 12 of a generally rectangle in plan formed in the movable electrode supporting frame 10; two elastic and flexible beams 21 for supporting the movable plate-like electrode 2 to be movable toward and away from the stationary electrode substrate 8, that is, for supporting it for up and down or vertical motion, each beam having a plurality of meanders or sharply turning portions; and a mirror 3 formed on the central portion of the top surface of the movable plate-like electrode 2 in the direction of one diagonal line thereof.
Each of the elastic and flexible beams 21 is called "flexure" and one end thereof is fixed integrally to corresponding one of the two opposed sides of the movable plate-like electrode 2 generally on the center of the side, the two sides being opposed to each other in the longitudinal direction of the movable electrode supporting frame 10, and the other end thereof is formed into an anchor portion 21A of a generally square in plan which is, in turn, fixed to corresponding one of the two longitudinally opposed sides of the movable electrode supporting frame 10 generally on the center of the side. On the top surfaces of the anchor portions 21A are formed electrodes 83, respectively. Further, on the top surfaces of the centers of the two longitudinally opposed sides of the movable electrode supporting frame 10 on which the anchor portions 21A of the beams 21 are secured, are formed insulation layers (for example, $SiO_2$ layers) 11 as will be described later on, and hence the beams 21 are electrically insulated from the movable electrode supporting frame 10.
The movable electrode supporting frame 10, two beams 21 and movable plate-like electrode 2 are formed into one body, and they may be fabricated from, for example, an SOI (Silicon on Insulator) substrate of a generally rectangle in plan by use of micromachining technology. The manufacturing method thereof will be described later. Further, it is needless to say that the opening 12 of a generally rectangle formed in the movable electrode supporting frame 10 has such a size that it can accommodate the movable plate-like electrode 2 and two beams 21 therein.
The stationary electrode substrate 8 is a substrate made of, for example, single crystal silicon (Si) of a generally rectangle in plan and of a predetermined thickness, and in this example, on the overall top and bottom surfaces thereof are formed insulation layers (for example, $SiO_2$ layers) 85T and 85B, respectively. In order to form an electrode on the stationary electrode substrate 8, a portion (in the illustrated example, a top right corner portion in Fig. 1) of the top insulation layer 85T is removed to expose the inner silicon substrate, and an electrode 84 is formed on the exposed inner silicon substrate. This electrode 84 is usually used as a ground electrode.
The movable electrode supporting frame 10 is put on the stationary electrode substrate 8 constructed as described above, and they are formed into one body. As will be described later, on the bottom surface of the movable electrode supporting frame 10 is also formed an insulation layer (for example, $SiO_2$ layer) 10B, and hence the unified stationary electrode substrate 8 and movable electrode supporting frame 10 are electrically insulated from each other by the insulation layer 85T on the top surface of the stationary electrode substrate 8 and the insulation layer 10B on the bottom surface of the movable electrode supporting frame 10. Further, as shown in Fig. 1, the electrode 84 on the stationary electrode substrate 8 is to be formed such that it is located at the outside of the movable electrode supporting frame 10 put on the stationary electrode substrate 8.

A method of fabricating the movable electrode supporting frame 10, and the two beams 21 and movable plate-like electrode 2 integrally formed with the movable electrode supporting frame 10 will be described with reference to Figs. 3A to 3H.

At first, as shown in Fig. 3A, an SOI substrate 1 of a generally rectangle in plan is prepared. In general, the SOI substrate 1 is constituted by a support substrate 14 of single crystal silicon, an insulation layer 11 on the top surface of the support substrate 14, and a thin layer 16 of single crystal silicon on the top surface of the insulation layer 11. In this example, there is used an SOI substrate 1 comprising a support substrate 14 of single crystal silicon, an insulation layer 11 of $SiO_2$ layer formed on the top surface of the support substrate 14, and a thin layer 16 of single crystal silicon joined onto the top surface of the $SiO_2$ layer 11. However, it goes without saying that any SOI substrate manufactured by use of one of known other methods or processes may be used. As stated above, in this example, the insulation layer (for example, $SiO_2$ layer) 10B is previously formed on the bottom surface of the SOI substrate 1 as shown in Fig. 3A.

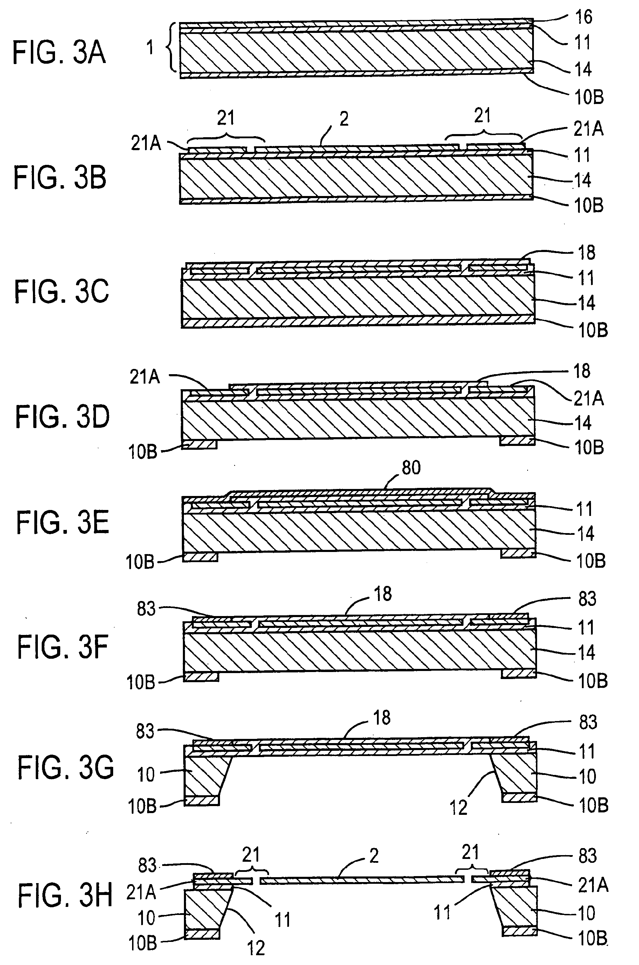

Next, by use of photolithography technology, a patterning of the thin layer 16 of single crystal silicon of the SOI substrate 1 is done to leave portions thereof corresponding to shapes of the two beams 21 (including the anchor portions 21A) and the movable plate-like electrode 2 as shown in Fig. 3B.

Then, the overall surfaces of the SOI substrate 1 are oxidized. As a result, as shown in Fig. 3C, an $SiO_2$ layer 18 is formed on the beams 21 and the movable plate-like electrode 2 as well as on the exposed insulation layer 11, and also the thickness of the $SiO_2$ layer 10B on the bottom surface of the SOI substrate 1 is thicker.

Next, as shown in Fig. 3D, $SiO_2$ layers on the top surfaces of the anchor portions 21A of the beams 21 in the $SiO_2$ layer 18 on the top surface of the SOI substrate 1 are removed as well as an $SiO_2$ layer corresponding to the opening 12 of the movable electrode supporting frame 10 in the $SiO_2$ layer 10B on the bottom surface of the SOI substrate 1 is removed to expose the top surfaces of the anchor portions 21A and the bottom surface of the support substrate 14 except for the peripheral portion thereof.

Then, as shown in Fig. 3E, a double layer 80 of gold and chromium is formed on the overall top surface of the SOI substrate 1. Thereafter, as shown in Fig. 3F, the gold/chromium double layer 80 is removed except for portions thereof on the top surfaces of the anchor portions 21A of the beams 21 so that the electrodes 83 consisting of the gold/chromium double layer 80 are formed on the top surfaces of the anchor portions 21A, respectively.

Next, the support substrate 14 is etched from the bottom surface side of the SOI substrate 1 using KOH solution to form an opening 12 as shown in Fig. 3G. As a result, the movable electrode supporting frame 10 of a generally rectangle in plan is formed from the support substrate 14.

Thereafter, the $SiO_2$ layers 11 and 18 remaining on the top surface side of the SOI substrate 1 are removed except for portions of the $SiO_2$ layer 11 existing between the top surface of the movable electrode supporting frame 10 and the bottom surfaces of the anchor portions 21A of the beams 21, as shown in Fig. 3H. Thus, there are formed the movable electrode supporting frame 10 having the same construction and structure as those of the movable electrode supporting frame 10 shown in Figs. 1 and 2 together with the two beams 21 and movable plate-like electrode 2 integrally formed with the movable electrode supporting frame 10.

Further, a process of fabricating the mirror 3 to be formed on the top surface of the movable plate-like electrode 2 in the direction of one diagonal line thereof is omitted. However, in Japanese Patent Application No. 295037/1998 filed on October 16, 1998 by the same applicant as that of the present application or Japanese Patent Application No. 348378/2000 filed on November 15, 2000 by the same applicant as that of the present application, though the disclosed optical switches do not have an SOI substrate used therein, a process of fabricating a mirror is described. Therefore, a detailed explanation of the manufacturing process of a mirror will be referred to Japanese Patent Application Public Disclosure Nos. 121967/2000 and 148531/2002 that are public disclosures of these Japanese Patent Application Nos. 295037/1998 and 348378/2000. In addition, the prior optical switch shown in Figs. 1 and 2 is described as a prior art in Japanese Patent Application No. 227613/2001 filed on July 27, 2001 by the same applicant as that of the present application.

As described above, the stationary electrode substrate 8 is manufactured as a separate body, and the insulation layers (for example, $SiO_2$ layers) 85T and 85B are formed on the overall top and bottom surfaces of the stationary electrode substrate 8, respectively. The movable electrode supporting frame 10 constructed as described above is put on the insulation layer 85T formed on the top surface of the stationary electrode substrate 8, and then, they are united. Accordingly, the stationary electrode substrate 8 and the movable electrode supporting frame 10 are electrically insulated from each other by the insulation layers 85T and 10B.

Next, the operation of the optical switch SW1 constructed as discussed above will be described. As shown in Fig. 1, an input side optical waveguide, namely, an optical fiber 4 in this example, for inputting an optical signal L into the optical switch SW1 is located at the left side of the optical switch SW1 in the drawing. An output side optical waveguide, namely, an optical fiber 5 in this example, for transmitting the optical signal L supplied from the optical switch SW1 is aligned with the input side optical fiber 4 along a straight line passing through the mirror 3 at an angle of about 45° with the mirror surface of the mirror 3, and another output side optical waveguide, namely, an optical fiber 6 in this example, for transmitting the optical signal L supplied from the optical switch SW is disposed on a straight line that passes through the mirror 3 and that is orthogonal to the aforesaid straight line.

As described above, since the mirror 3 is placed on the central portion of the movable plate-like electrode 3 along a diagonal line thereof, the optical signal L that is outputted from the output end of the input side optical fiber 4 and goes right on in a space is incident on the mirror 3 at an angle of about 45° with the mirror surface of the mirror 3. As a result, the optical signal L is reflected by the mirror 3 in the direction of forming an angle of 90° (forming a right angle) with the incident light (the optical signal L is outputted from the mirror 3 at an angle of about 45° which is the same as the incident angle), and is transmitted to the input end of the output side optical fiber 6. In the specification, the transmission state of the optical signal L in which the optical signal L outputted from the input side optical fiber 4 is reflected by the mirror 3 and transmitted to the output side optical fiber 6 is defined as the steady state.

In the above steady state, in case of applying a predetermined voltage between the movable plate-like electrode 2 and the stationary electrode substrate 8 to generate an electrostatic force between the both electrodes in such manner that they are attracted each other, the two beams 21 are elastic and flexible and the stationary electrode substrate 8 is immovable, and hence the movable plate-like electrode 2 is driven downwardly toward the stationary electrode substrate 8. Accordingly, if a voltage applied between the movable plate-like electrode 2 and the stationary electrode substrate 8 is controlled to displace or drive the movable plate-like electrode 2 downwardly so that the mirror 3 fixed to the top surface of the movable plate-like electrode 2 is displaced or driven downwardly to a position where the mirror 3 is out of the optical path on which any optical signal outputted from the input side optical fiber 4 goes right on, the optical signal L outputted from the input side optical fiber 4 will go right on without being reflected by the mirror 3 and be transmitted to the output side optical fiber 5. Thus, the optical signal L incident on the optical switch SW1 can be switched to any one of the two output side optical fibers 5 or 6 for transmission to one desired output side optical fiber. In other words, the optical switch SW1 constructed as described above is capable of switching in space the path of an optical signal propagating through an optical waveguide or optical transmission line (path) without any intervention of a solid state optical waveguide.

In the above-configured prior optical switch SW1, in order to make it possible that the movable plate-like electrode 2 is driven toward the stationary electrode substrate 8 by application of a drive voltage as low as possible when a switching operation is performed, the thickness of the movable plate-like electrode 2 is much thin, and likewise, the thickness of the two beams 21 that support the movable plate-like electrode 2 to be movable toward and away from the stationary electrode substrate 8 is also much thin.

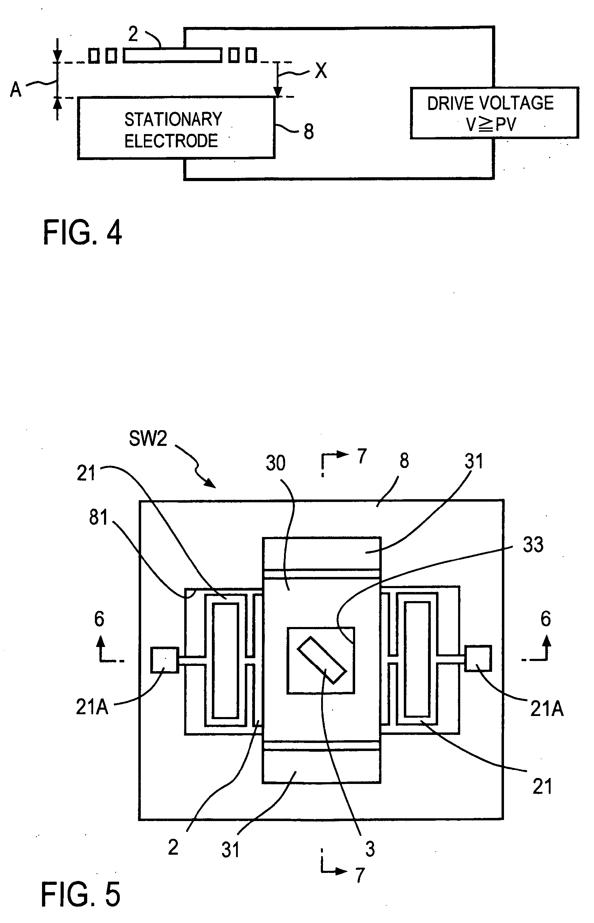

Moreover, in the prior art, as shown in Fig. 4, in case of driving the movable plate-like electrode 2 by a distance X downwardly (toward the stationary electrode substrate 8) for switching operation, a distance or gap A between the bottom surface of the movable plate-like electrode 2 and the top surface of the stationary electrode substrate 8 when any drive voltage is not applied therebetween, is set to a distance X that the movable plate-like electrode 2 is to be driven (the initial set value A=X), and between the movable plate-like electrode 2 and the stationary electrode substrate 8 is applied a predetermined drive voltage V that is capable of driving the movable plate-like electrode 2 by the distance X.

The relationship between the drive voltage to be applied to the movable plate-like electrode 2 and the distance that the movable plate-like electrode 2 is to be driven is not linear. It is characterized in that when the drive voltage applied to the movable plate-like electrode 2 is gradually increased, the movable plate-like electrode 2 is driven downwardly toward the stationary electrode substrate 8, and that when the driven distance of the movable plate-like electrode 2 becomes equal to or more than 1/3 of the distance A (in the prior art, A=X) between the movable plate-like electrode 2 and the stationary electrode substrate 8, that is, when a distance between the bottom surface of the movable plate-like electrode 2 already driven and the top surface of the stationary electrode substrate 8 opposite to the bottom surface of the electrode 2 is equal to or less than 2/3 of the initial set value X, the movable plate-like electrode 2 is driven at a dash toward the stationary electrode substrate 8 and is attracted or stuck to the top surface of the stationary electrode substrate 8. A drive voltage that drives the movable plate-like electrode 2 at a dash toward the stationary electrode substrate 8 is called "pull-in voltage".

In the prior art, since the movable plate-like electrode 2 is driven by the distance X, the predetermined drive voltage V is necessarily set to a voltage equal to or higher than the pull-in voltage PV. For this reason, when the movable plate-like electrode 2 moves over the distance equal to 1/3 of the initial set value X, it is driven at a dash toward the stationary electrode substrate 8 thereby to come into contact with the top surface of the substrate 8. Further, the pull-in voltage will be described later on in detail.

Furthermore, in the above-mentioned optical switch, the thickness of the movable plate-like electrode 2 and also the thickness of the two beams 21 are much thin as described above. Therefore, in the condition that any drive voltage is not applied between the movable plate-like electrode 2 and the stationary electrode substrate 8 (in the state that the movable plate-like electrode 2 and the stationary electrode substrate 8 are disposed substantially in parallel with each other with a predetermined gap or space), there are problems that the two beams 21 that mount the movable plate-like electrode 2 on the movable electrode supporting frame 10 through their anchor portions 21A are damaged by vibration or oscillation, and/or the movable plate-like electrode 2 vibrates or oscillates by being strongly affected by an external vibration or oscillation, thereby to become unstable in switching operation.

In order to resolve the above problems, there is proposed an optical switch that is constructed such that over the top surface of the movable plate-like electrode 2 is formed an upper plate-like electrode which functions to electrostatically attract the movable plate-like electrode 2, thereby to remove the above problems occurring in the condition that any drive voltage is not applied to the movable plate-like electrode 2. Such optical switch is disclosed in, for example, Japanese Patent Application No. 212336/1999 filed on July 27, 1999 by the same applicant as that of the present application. The optical switch described in the above-mentioned Japanese Patent Application No. 212336/1999 is shown in Figs. 5 to 7. Though this prior optical switch does not have an SOI substrate used therein, the technical concept thereof is the same as that of the proposed optical switch, and the second prior art will be briefly described with reference to Figs. 5 to 7.

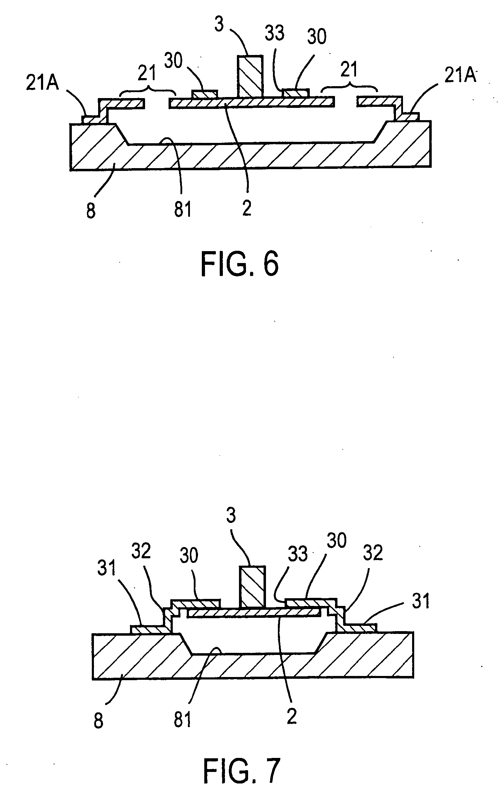

Fig. 5 is a plan view showing a construction of the second prior optical switch, Fig. 6 is a sectional view taken along the line 6-6 in Fig. 5 and looking in the direction indicated by the arrows, and Fig. 7 is a sectional view taken along the line 7-7 in Fig. 5 and looking in the direction indicated by the arrows. The illustrated optical switch SW2 comprises: a stationary or fixed electrode substrate 8 of a generally rectangle in plan and of, for example, n-type semiconductor silicon; a recess 81 of a generally rectangle in plan that is formed in the stationary electrode substrate 8 at the central portion of the top surface thereof; a movable plate-like electrode 2 of a generally square in plan that is disposed substantially in parallel with the stationary electrode substrate 8 above the central portion of the recess 81; two elastic and flexible beams 21 for supporting the movable plate-like electrode 2 to be movable toward and away from the stationary electrode substrate 8, that is, for supporting it for up and down or vertical motion, each beam having a plurality of meanders or sharply turning portions; a micro mirror 3 formed on the central portion of the top surface of the movable plate-like electrode 2 in the direction of one diagonal line thereof; and an upper plate-like electrode 30 of a generally rectangle in plan that has an opening 33 of a generally square in plan formed in the center thereof and extends over the top surface of the movable plate-like electrode 2 in the direction of the minor side of the rectangular recess 81, the opening 33 having a sufficient size that the micro mirror 3 passes through the opening 33 to project upward.

Each of the elastic and flexible beams 21 is called "flexure" and one end thereof is fixed integrally to corresponding one of the two opposed sides of the movable plate-like electrode 2 generally on the center of the side, the two sides of the electrode 2 being opposed to each other in the direction of the major side of the recess 81, and the other end thereof is formed into an anchor portion 21A of a generally square in plan which is, in turn, fixed to corresponding one of the two longitudinally opposed sides of the stationary electrode substrate 8 generally on the center of the side, the two sides of the substrate 8 being opposed to each other in the direction of the major side of the recess 81. Further, the movable plate-like electrode 2, two beams 21 and anchor portions 21A are formed into one body by a material of, for example, polycrystal silicon. In addition, it is needless to say that the generally rectangular recess 81 formed in the stationary electrode substrate 8 at the central portion of the top surface thereof has such a size that it can accommodate the movable plate-like electrode 2 and two beams 21 therein.

The upper plate-like electrode 30 has its opposite ends integrally connected to upright portions 32 which stand up respectively from upper electrode anchor portions 31 of a generally rectangle in plan. Each of the upper electrode anchor portions 31 integrally formed with the upright portions 32 is fixed to corresponding one of the two opposed sides of the stationary electrode substrate 8 on the top surface of generally the center of the side, the two sides of the substrate 8 being opposed to each other in the direction of the minor side of the recess 81. As a result, the upper plate-like electrode 30 of a generally rectangle in plan is supported by the stationary electrode substrate 8 such that the electrode 30 extends over the top surface of the movable plate-like electrode 2. The upper plate-like electrode 30 can be also formed of a material of, for example, polycrystal silicon, like the movable plate-like electrode 2. Further, the upper plate-like electrode 30 having the opening 33, upright portions 32 and upper electrode anchor portions 31 are formed into one body by a material of polycrystal silicon.

In practice, the movable plate-like electrode 2, two beams 21 and anchor portions 21A as well as the upper plate-like electrode 30 having the opening 33, upright portions 32 and upper electrode anchor portions 31 are formed on the stationary electrode substrate 8 using a material of polycrystal silicon, and the movable plate-like electrode 2 and the upper plate-like electrode 30 are fixed to the stationary electrode substrate 8 at predetermined positions of the top surface thereof. The stationary electrode substrate 8 having the recess 81, the movable plate-like electrode 2 having the mirror 3 formed on the top surface thereof, the two beams 21, the anchor portions 21A, the upper plate-like electrode 30 having the opening 33, the upright portions 32 and the upper electrode anchor portions 31 are manufactured by use of micromachining technology, and the manufacturing method will be referred to Japanese Patent Application Public Disclosure No. 42233/2001 that is a public disclosure of the above-mentioned Japanese Patent Application No. 212336/1999.

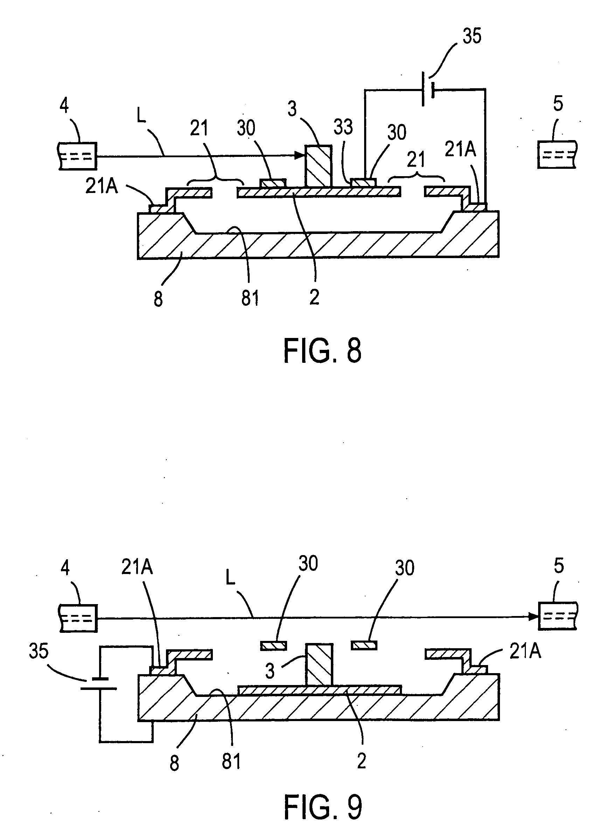

Next, the operation of the optical switch SW2 constructed as discussed above will be described with reference to Figs. 8 and 9. In Fig. 5, though not shown, an input side optical waveguide, for example, an optical fiber for inputting an optical signal into the optical switch SW2 is located at the left side of the optical switch SW2 in the drawing, and an output side optical waveguide, for example, an optical fiber for transmitting the optical signal supplied from the optical switch SW2 is located at the right side of the optical switch SW2 in the drawing. That is, these input side optical fiber and output side optical fiber are aligned on a straight line passing through the mirror 3 at an angle of about 45° with the mirror surface of the mirror 3. In addition, another output side optical waveguide, for example, an optical fiber for transmitting the optical signal supplied from the optical switch SW2 is disposed on a straight line that passes through the minor 3 and that is orthogonal to the aforesaid straight line (in this example, the another output side optical fiber is located at the down side of the optical switch SW2 in Fig. 5).

As shown in Figs. 6 and 7, the movable plate-like electrode 2 and the upper plate-like electrode 30 are substantially in contact with each other. In order to secure such contact state between the both electrodes 2 and 30, as shown in Fig. 8, the positive electrode of a drive power supply 35 is connected to the upper plate-like electrode 30 and the negative electrode thereof is connected to the anchor portion 21A thereby to apply a predetermined drive voltage between the movable plate-like electrode 2 and the upper plate-like electrode 30. By this electrical connection, the movable plate-like electrode 2 is attracted to the upper plate-like electrode 30 so that they are maintained in the state that the top surface of the movable plate-like electrode 2 and the bottom surface of the upper plate-like electrode 30 are certainly in contact with each other.

As described above, since the mirror 3 is placed on the central portion of the movable plate-like electrode 3 along a diagonal line thereof, the optical signal L that is outputted from the output end of an input side optical fiber 4 and goes right on in a space is incident on the mirror 3 at an angle of about 45° with the mirror surface of the mirror 3. As a result, the optical signal L is reflected by the mirror 3 in the direction of forming an angle of 90° with the incident light (the optical signal L is outputted upwardly in the direction perpendicular to the drawing paper surface from the mirror 3 at an angle of about 45° which is the same as the incident angle), and is transmitted to the input end of an output side optical fiber that is located at the upper side in the direction perpendicular to the drawing paper surface.

In the above-mentioned state, as shown in Fig. 9, when the positive electrode of the drive power supply 35 is connected to the stationary electrode substrate 8 and the negative electrode thereof is connected to the anchor portion 21A thereby to apply a predetermined drive voltage between the movable plate-like electrode 2 and the stationary electrode substrate 8, an electrostatic attraction occurs in such direction that the movable plate-like electrode 2 is attracted toward the stationary electrode substrate 8 so that the electrode 2 is downwardly driven toward the substrate 8 and comes into contact therewith. As a result, the mirror 3 fixed to the top surface of the movable plate-like electrode 2 is displaced downwardly to a position where the mirror 3 is out of the optical path on which any optical signal outputted from the input side optical fiber 4 goes right on, the optical signal L outputted from the input side optical fiber 4 will go right on without being reflected by the mirror 3 and be transmitted to another output side optical fiber 5.

Thus, the optical signal L incident on the optical switch SW2 can be switched to any one of the two output side optical fibers for transmission to one desired output side optical fiber. In other words, the optical switch SW2 constructed as described above is capable of switching in space the path of an optical signal propagating through an optical waveguide or optical transmission line (path) without any intervention of a solid state optical waveguide.

In the second prior art optical switch SW2 constructed as described above, when a switching operation is carried out, the movable plate-like electrode 2 is attracted to either one of the upper plate-like electrode 30 or the stationary electrode substrate 8 and they are held in attracted state. Accordingly, there do not occur problems that the two beams 21 supporting the movable plate-like electrode 2 on the stationary electrode substrate 8 through their anchor portions 21A are damaged by vibration or oscillation, and/or the movable plate-like electrode 2 vibrates or oscillates by being strongly affected by an external vibration or oscillation so that a switching operation becomes unstable.

In the first and second prior electrostatically operated devices (optical switches) discussed above, in general, it is desirable in circuit design to make it possible that the movable plate-like electrode 2 is driven toward the stationary electrode substrate 8 by application of a drive voltage as low as possible. In other words, it is desirable in circuit design to reduce the absolute value of a drive voltage for driving the movable plate-like electrode 2 toward the stationary electrode substrate 8 to a value as small as possible.

However, in the first prior art, in case of driving the movable plate-like electrode 2 by a distance X toward the stationary electrode substrate 8, as already described with reference to Fig. 4, a drive voltage V equal to or greater than the pull-in voltage, the drive voltage V being capable of driving the movable plate-like electrode 2 by the distance X, is applied between the movable plate-like electrode 2 and the stationary electrode substrate 8 thereby to produce from the stationary electrode substrate 8 an electrostatic attraction that is capable of attracting the movable plate-like electrode 2 against the force of restitution of the two beams 21 for supporting the movable plate-like electrode 2 to be movable toward and away from the stationary electrode substrate 8. That is, it is arranged that the movable plate-like electrode 2 is attracted to the stationary electrode substrate 8 against the force of restitution of the two beams 21 by only the electrostatic attraction produced from the stationary electrode substrate 8. For that reason, even if the thickness of the movable plate-like electrode 2 is made thin to lighten the weight thereof, and also even if the thickness of the beams 21 is made thin to lessen their elastic forces, the two beams 21 must have their elastic forces for holding the movable plate-like electrode 2 substantially in parallel with the stationary electrode substrate 8 and for returning the movable plate-like electrode 2 already attracted to the stationary electrode substrate 8 to its original position therefrom. Therefore, there is a limit in reducing the magnitude of the drive voltage that is required to drive the movable plate-like electrode 2 by the distance X toward the stationary electrode substrate 8.

The same is true of the second prior electrostatically operated device shown in Figs. 5 to 7. In the second prior art, the upper plate-like electrode 30 is provided for the purpose of attracting and securing the movable plate-like electrode 2 so that the electrode 2 is not affected by any external vibration or oscillation, as already described above. Basically, in the condition that any drive voltage is not applied, the upper plate-like electrode 30 is located at a position of elevation that the top surface of the movable plate-like electrode 2 is substantially in contact with the bottom surface of the upper plate-like electrode 30. Accordingly, a driving operation itself for moving the movable plate-like electrode 2 already attracted to the upper plate-like electrode 30 toward the stationary electrode substrate 8 by the distance X after the attracted state of the electrode 30 to the substrate 8 is canceled, is the very same as in the first prior art, and hence there is a limit in reducing the magnitude of the drive voltage that is required to drive the movable plate-like electrode 2 by the distance X toward the stationary electrode substrate 8. In other words, in the electrostatically operated device arranged such that the movable plate-like electrode 2 is driven toward and attracted to the stationary electrode substrate 8 by only the electrostatic attraction produced from the stationary electrode substrate 8, it has a limitation to reduce the magnitude of the drive voltage.

## SUMMARY OF THE INVENTION

It is an object of the present invention to provide an electrostatically operated device in which the magnitude of a drive voltage can be considerably reduced as compared with the prior art electrostatically operated device.

It is another object of the present invention to provide an electrostatically operated device that comprises: a stationary electrode substrate; a movable plate-like electrode disposed substantially in parallel with the stationary electrode substrate with a predetermined gap therebetween; and a second stationary plate-like electrode disposed substantially in parallel with the movable plate-like electrode with a predetermined gap therebetween, and that it is arranged such that a drive voltage greater than the pull-in voltage is applied between the second stationary plate-like electrode and the movable plate-like electrode or between the stationary electrode substrate and the movable plate-like electrode thereby to cause the movable plate-like electrode to be attracted to the second stationary plate-like electrode or to the stationary electrode substrate.

It is further object of the present invention to provide an electrostatically operated device that comprises: a stationary electrode substrate; a movable plate-like electrode disposed substantially in parallel with the stationary electrode substrate with a predetermined gap therebetween; and a second stationary plate-like electrode disposed substantially in parallel with the movable plate-like electrode with a predetermined gap therebetween, and that it is arranged such that a drive voltage smaller than the pull-in voltage is applied between the second stationary plate-like electrode and the movable plate-like electrode or between the stationary electrode substrate and the movable plate-like electrode thereby to displace the movable plate-like electrode toward the second stationary plate-like electrode or toward the stationary electrode substrate.

In order to accomplish the above objects, in an aspect of the present invention, there is provided an electrostatically operated device manufactured by use of micromachining technology which comprises: a stationary electrode substrate; a movable plate-like electrode disposed substantially in parallel with the stationary electrode substrate with a predetermined gap therebetween; a second stationary plate-like electrode disposed substantially in parallel with the movable plate-like electrode with a predetermined gap therebetween; and means for supporting the movable plate-like electrode to be movable between the second stationary plate-like electrode and the stationary electrode substrate, wherein the movable plate-like electrode is maintained at a position that is away by a first predetermined distance from the stationary electrode substrate and by a second predetermined distance from the second stationary plate-like electrode when any drive voltage is not applied between the second stationary plate-like electrode and the movable plate-like electrode as well as between the stationary electrode substrate and the movable plate-like electrode, and the movable plate-like electrode being electrostatically driven toward the second stationary plate-like electrode by applying a drive voltage between the second stationary plate-like electrode and the movable plate-like electrode, or the movable plate-like electrode being electrostatically driven toward the stationary electrode substrate by applying a drive voltage between the stationary electrode substrate and the movable plate-like electrode.

In a preferred embodiment, a drive voltage applied between the second stationary plate-like electrode and the movable plate-like electrode, or a drive voltage applied between the stationary electrode substrate and the movable plate-like electrode is a voltage more than the pull-in voltage, and the movable plate-like electrode is maintained in a state that it is attracted to the second stationary plate-like electrode, or in a state that it is attracted to the stationary electrode substrate.

In a second preferred embodiment, a drive voltage applied between the second stationary plate-like electrode and the movable plate-like electrode, or a drive voltage applied between the stationary electrode substrate and the movable plate-like electrode is a voltage less than the pull-in voltage, and the movable plate-like electrode is maintained in a state that it is displaced less than the pull-in displacement toward the second stationary plate-like electrode, or in a state that it is displaced less than the pull-in displacement toward the stationary electrode substrate.

The electrode-to-electrode distance between the second stationary plate-like electrode and the stationary electrode substrate is set to a value that is greater than three times the sum of a distance that the movable plate-like electrode is moved toward the second stationary plate-like electrode and a distance that the movable plate-like electrode is moved toward the stationary electrode substrate when the movable plate-like electrode is electrostatically driven by application of a voltage less than the pull-in voltage.

It is preferred that the movable plate-like electrode is maintained at a position that is away by the same distance from the stationary electrode substrate and from the second stationary plate-like electrode when any drive voltage is not applied between the second stationary plate-like electrode and the movable plate-like electrode as well as between the stationary electrode substrate and the movable plate-like electrode.

In addition, a first switch for turning on or off a drive voltage applied between the second stationary plate-like electrode and the movable plate-like electrode, and a second switch for turning on or off a drive voltage applied between the stationary electrode substrate and the movable plate-like electrode are provided, and either one of a state that no drive voltage is applied, a state that a drive voltage is applied between the second stationary plate-like electrode and the movable plate-like electrode, or a state that a drive voltage is applied between the stationary electrode substrate and the movable plate-like electrode is selected by on/off operations of the first and second switches.

With the construction as described above, the movable plate-like electrode is driven by the attraction produced from the second stationary plate-like electrode or the stationary electrode substrate. As a result, the magnitude of the drive voltage can be reduced to about 0.35 times that of the prior art electrostatically operated device, namely, about 1/3 of the drive voltage of the prior art electrostatically operated device at the maximum.

BRIEF DESCRIPTION OF THE DRAWINGS

Fig. 1 is a plan view showing the construction of an example of the prior art electrostatically operated device;
Fig. 2 is a sectional view taken along the line 2-2 in Fig. 1 and looking in the direction indicated by the arrows;
Figs. 3A to 3H are sectional views for explaining a method of manufacturing a movable electrode supporting frame, a movable plate-like electrode and two beams of the electrostatically operated device shown in Fig. 1 in a sequence of manufacturing processes;
Fig. 4 is a block diagram illustrating roughly the main components of the electrostatically operated device shown in Fig. 1;
Fig. 5 is a plan view showing the construction of another example of the prior art electrostatically operated device;
Fig. 6 is a sectional view taken along the line 6-6 in Fig. 5 and looking in the direction indicated by the arrows;
Fig. 7 is a sectional view taken along the line 7-7 in Fig. 5 and looking in the direction indicated by the arrows;
Fig. 8 is substantially the same sectional view as Fig. 6 for explaining the switching operation of the electrostatically operated device shown in Fig. 5;
Fig. 9 is substantially the same sectional view as Fig. 6 for explaining the switching operation of the electrostatically operated device shown in Fig. 5;

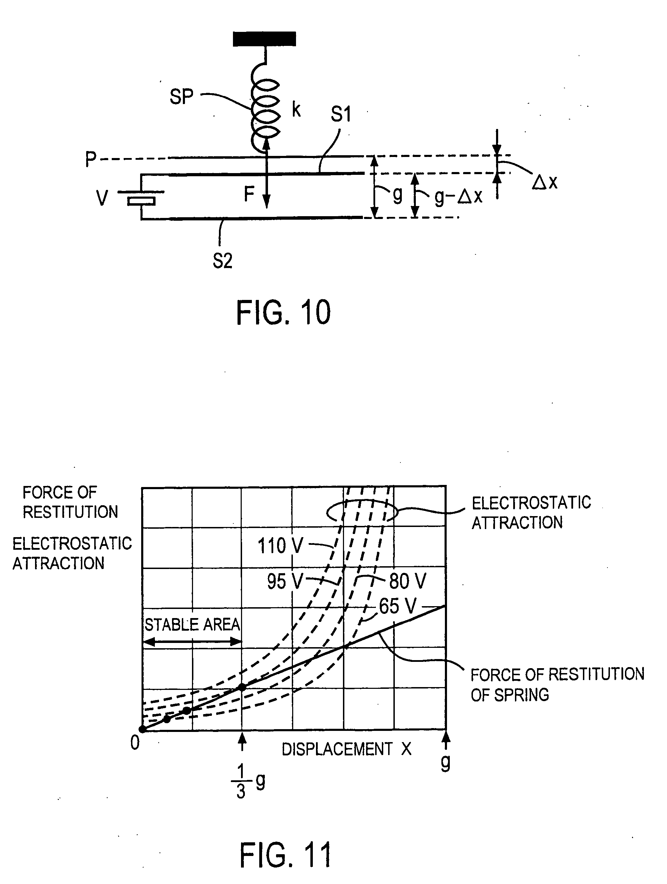

Fig. 10 is a diagrammatical view for explaining the principle of operation of a parallel plate type electrostatically operated actuator that is the principle of the present invention;
Fig. 11 is a graph showing the relationship of the electrostatic attraction and the force of restitution to the displacement of the electrostatically operated actuator shown in Fig. 9;

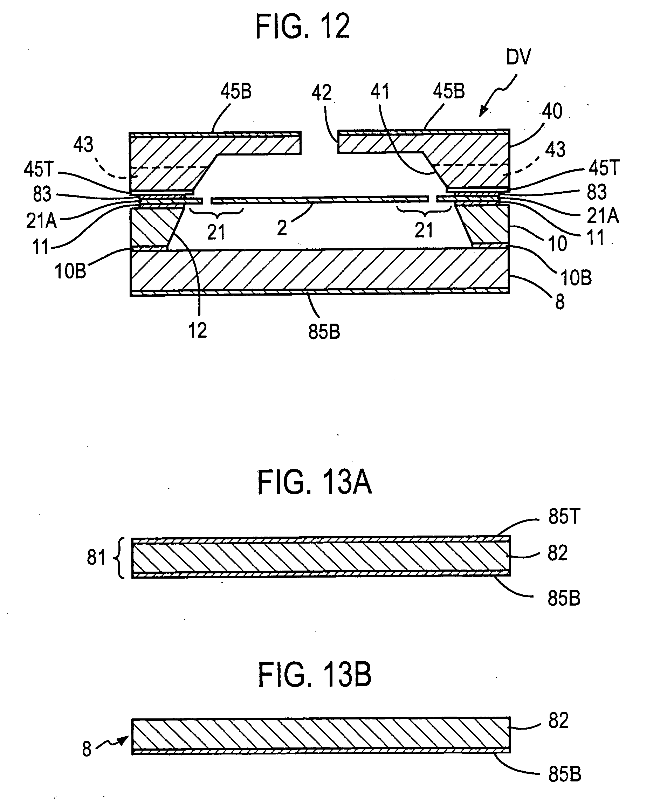

Fig. 12 is a sectional view showing a basic construction of the electrostatically operated device according to the present invention;
Figs. 13A and 13B are sectional views showing a method of manufacturing a lower stationary electrode substrate of the electrostatically operated device shown in Fig. 12;

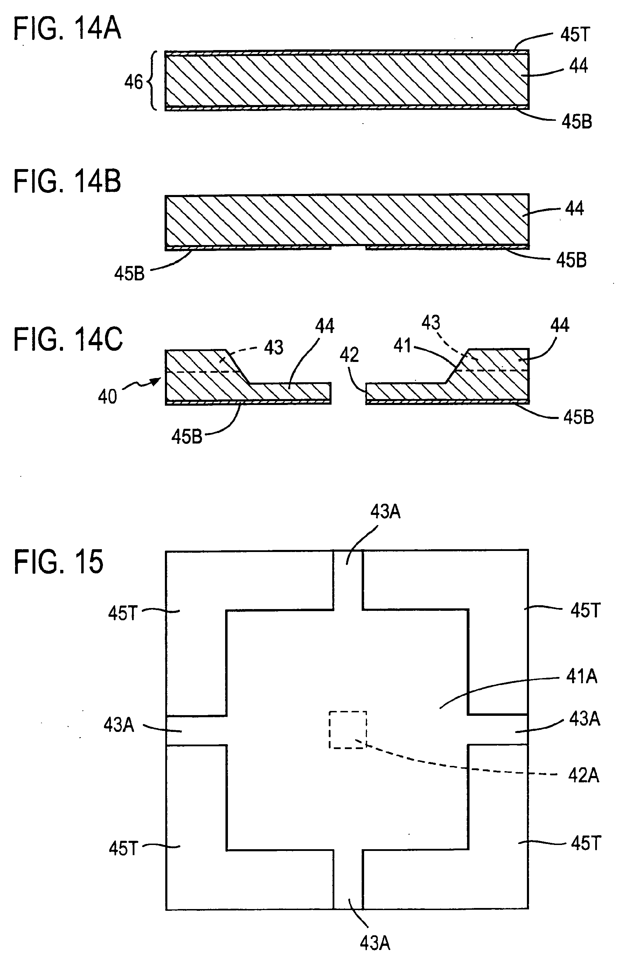

Figs. 14A to 14C are sectional views showing a method of manufacturing an upper stationary plate-like electrode of the electrostatically operated device shown in Fig. 12 in a sequence of manufacturing processes;
Fig. 15 is a plan view of Fig. 14B;

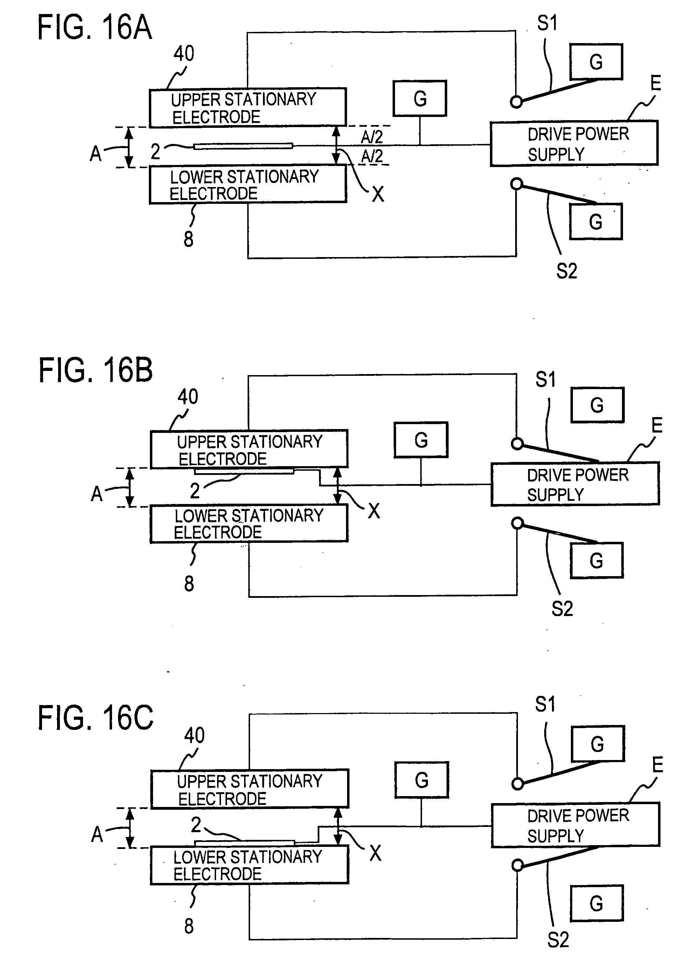

Figs. 16A to 16C are block diagrams illustrating roughly the main components and for explaining the operation of a first embodiment of the electrostatically operated device according to the present invention; and

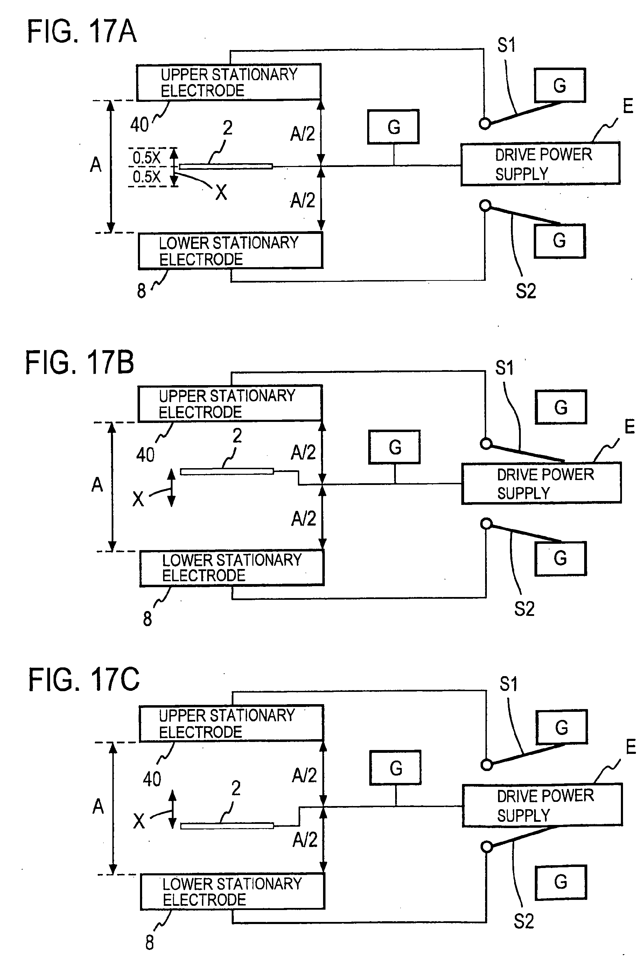

Figs. 17A to 17C are block diagrams illustrating roughly the main components and for explaining the operation of a second embodiment of the electrostatically operated device according to the present invention.

DETAILED DESCRIPTION OF THE PREFERRED EMBODIMENTS

The preferred embodiments of the present invention will now be described in detail with reference to the accompanying drawings. The present invention may, however, be embodied in many different forms and should not be construed as limited to the embodiments set forth hereinafter; rather, the embodiments are provided so that this disclosure will be thorough and complete, and will fully convey the scope of the invention to those skilled in the art.

Before the preferred embodiments of the present invention will be described, the relationship between the electrostatic attraction and the force of restitution of a parallel plate type electrostatically operated actuator that is the principle of the present invention, and the pull-in voltage will be briefly described with reference to an article announced by Professor Hiroshi TOSHIYOSHI, Institute of Industrial Science, University of Tokyo.

Fig. 10 is a diagrammatical view for explaining the principle of operation of a parallel plate type electrostatically operated actuator. It is assumed that in the initial state in which any drive voltage is not applied, a distance between a movable plate-like electrode S1 and a stationary plate-like electrode S2 opposed to each other is g, and that when a drive voltage V is applied between the movable plate-like electrode S1 and the stationary plate-like electrode S2, the movable plate-like electrode S1 is displaced by $\Delta x$ toward the stationary plate-like electrode S2 from the initial position P. At that time, a distance between the movable plate-like electrode S1 and the stationary plate-like electrode S2 becomes $g - \Delta x$. Where, assuming that sprig constant of the spring SP is k, dielectric constant of a space between the two plate-like electrodes S1 and S2 is $\varepsilon_0$, area of each of the two plate-like electrodes S1 and S2 is S, and that force of restitution $k\Delta x$ of the spring SP equilibrates with electrostatic attraction F acting on the movable plate-like electrode S1 the following equation (1) is formed.

$$k\Delta x = \frac{1}{2} \cdot \frac{\varepsilon_0 S}{(g - \Delta x)^2} \cdot V^2 \tag{1}$$

When separation of variables is made in the above equation (1), the following equation is formed.

$$\Delta x (g - \Delta x)^2 = \varepsilon_0 S V^2 / 2k$$

The left side term $\Delta x (g - \Delta x)^2$ of the above equation is differentiated and a displacement at which the gradient is to become zero is found.

$$\{\Delta x(g - \Delta x)^2\}' = (g - \Delta x)^2 + \Delta x \cdot 2(g - \Delta x) \cdot (-1)$$
$$= (\Delta x - g)(3\Delta x - g) = 0$$

Therefore, the pull-in displacement $\Delta x_{PULL-IN}$ of the movable plate-like electrode S1 and the pull-in voltage $V_{PULL-IN}$ at that time become as shown in the following equations (2) and (3).

$$\Delta x_{PULL-IN} = g/3 \tag{2}$$

$$V_{PULL-IN} = \sqrt{\frac{8kg^3}{27\varepsilon_0 S}} \tag{3}$$

As can be understood from the above equations (2) and (3), when the movable plate-like electrode S1 is displaced by a distance past 1/3 of g (g is the initial set value of the electrode-to-electrode distance), that is, the movable plate-like electrode S1 is displaced beyond the pull-in displacement $\Delta x_{PULL-IN}$ determined by the equation (2), what is called the pull-in phenomenon occurs in which the movable plate-like electrode S1 is driven at a dash toward the stationary plate-like electrode S2 thereby to be attracted to the top surface of the electrode S2. Looking at the same phenomenon from the drive voltage, when a drive voltage equal to or higher than the pull-in voltage $V_{PULL-IN}$ determined by the equation (3) is applied between the both plate-like electrodes, the movable plate-like electrode S1 is displaced past the pull-in displacement $\Delta x_{PULL-IN}$ and so the pull-in phenomenon occurs. As a result, the movable plate-like electrode S1 is driven at a dash toward the stationary plate-like electrode S2 and attracted to the top surface of the electrode S2. On the contrary, if a drive voltage applied to the movable plate-like electrode S1 is lower than the pull-in voltage $V_{PULL-IN}$, then the displacement of the movable plate-like electrode S1 does not reach the pull-in displacement $\Delta x_{PULL-IN}$, that is, is less than the pull-in displacement $\Delta x_{PULL-IN}$, and hence the pull-in phenomenon does not occur and the movable plate-like electrode S1 remains stopped at the position where it has been displaced.

Showing the relationship of the force of restitution and the electrostatic attraction corresponding to the left side term and the right side term of the above equation (1) respectively to the displacement of the movable plate-like electrode S1 as a graph, it is as shown in Fig. 11. In the example shown in Fig. 11, the pull-in voltage $V_{PULL-IN}$ is 95 V, and if a voltage greater than the pull-in voltage $V_{PULL-IN}$ is applied, the electrostatic attraction comes to stronger than the force of restitution of the spring, which results in that the movable plate-like electrode S1 is driven at a dash toward the stationary plate-like electrode S2 and attracted to the top surface of the electrode S2. On the contrary, if a drive voltage lower than the pull-in voltage $V_{PULL-IN}$ is applied to the movable plate-like electrode S1, the balanced point between the electrostatic attraction and the force of restitution resides in a stable area between 0 and g/3 (a position at 1/3 of the initial set value g of the electrode-to-electrode distance) of the displacement, and the displaced distance of the movable plate-like electrode S1 is less than the pull-in displacement $\Delta x_{PULL-IN}$. Accordingly, it will be comprehended that unless a displacement more than the pull-in displacement $\Delta x_{PULL-IN}$ is given to the movable plate-like electrode S1, the pull-in phenomenon in which the movable plate-like electrode S1 is driven at a dash toward the stationary plate-like electrode S2 does not occur. Further, the details of the electrostatically operated actuator described above will be referred to the homepage of Professor Hiroshi TOSHIYOSHI, Institute of Industrial Science, University of Tokyo: http://toshi.fujita3.iis.u-tokyo.ac.jp/onlinelecture/electrostaticl .pdf.

The present invention is attained by aiming at the above-described principle, and at first, a basic construction of the electrostatically operated device according to the present invention will be described with reference to Fig. 12. Further, in Fig. 12, portions and elements corresponding to those shown in Figs. 1 to 3 will be denoted by the same reference characters attached thereto, and explanation thereof will be omitted unless necessary.

Fig. 12 is a sectional view showing a basic construction of the electrostatically operated device according to the present invention. This electrostatically operated device DV comprises: a lower stationary electrode substrate 8 of a generally square in plan; a movable electrode supporting frame 10 of a generally square in plan, that has substantially the same size as that of the lower stationary electrode substrate 8 and has an opening 12 of a generally rectangle or square formed in the central portion thereof; an upper stationary plate-like electrode 40 of a generally square in plan, that has substantially the same size as that of the lower stationary electrode substrate 8; a recess 41 of a generally square in plan that is formed in the upper stationary plate-like electrode 40 at the central portion of the bottom surface thereof; a movable plate-like electrode 2 of a generally square in plan, that is disposed at an intermediate position between the lower stationary electrode substrate 8 and the upper stationary plate-like electrode 40 and substantially in parallel with them; and two elastic and flexible beams (each called "flexure") 21 for supporting the movable plate-like electrode 2 to be movable between the lower stationary electrode substrate 8 and the upper stationary plate-like electrode 40.

Each of the elastic and flexible beams 21 has one end that is fixed integrally to corresponding one of the two opposed sides of the movable plate-like electrode 2 generally on the center of the side, the two opposed sides being opposed in the direction of the horizontal central line of the movable plate-like electrode 2 in the drawing, and the other end thereof is formed into an anchor portion 21A of a generally square in plan which is, in turn, fixed to corresponding one of the two opposed sides of the lower stationary electrode substrate 8 generally on the center of the top surface of the side, the two opposed sides also being opposed in the direction of the horizontal central line of the lower stationary electrode substrate 8 in the drawing.

Further, the spring SP shown in Fig. 10 corresponds to the two elastic and flexible beams (flexures) 21 for supporting the movable plate-like electrode 2 of the electrostatically operated device shown in Fig. 12 to be movable.

In case the illustrated electrostatically operated device will be applied to an optical switch, it will be configured, for example, such that a mirror is formed on the central portion of the top surface of the movable plate-like electrode 2 in the direction of one diagonal line thereof, a through hole 42 is formed in the central portion of the upper stationary plate-like electrode 40 so that the mirror can move upwardly, and a plurality of optical transmission paths or waveguides 43 shown by dotted lines through which an optical signal passes or propagates are formed in the bottom side of the upper stationary plate-like electrode 40 (one or more optical transmission paths or waveguides also being formed in the direction perpendicular to the drawing paper surface). Therefore, if there is no need to form a mirror or any other protrusion on the top surface of the movable plate-like electrode 2, it is not necessary to form the through hole 42 in the central portion of the upper stationary plate-like electrode 40.

The movable electrode supporting frame 10, two beams 21 and movable plate-like electrode 2 are formed into one body, and they may be fabricated from, for example, an SOI substrate of a generally square in plan by use of micromachining technology. The manufacturing method thereof is substantially the same as the prior art manufacturing method already described with reference to Fig. 3, and explanation thereof will be omitted. Further, it is needless to say that the opening 12 of a generally rectangle or square formed in the movable electrode supporting frame 10 and the recess 41 of a generally square formed in the upper stationary plate-like electrode 40 have such a size that they can accommodate the movable plate-like electrode 2 and two beams 21 therein.

The lower stationary electrode substrate 8 is fabricated in this embodiment by preparing, as shown in Fig. 13A, a substrate 81 of a generally square in plan which comprises a substrate 82 of single crystal silicon of a generally square in plan and of a predetermined thickness, and insulation layers (for example, $SiO_2$ layers) 85T and 85B previously formed on the overall top and bottom surfaces of the substrate 82 respectively, and by removing the top insulation layer 85T of the substrate 81 as shown in Fig. 13B thereby to expose the top surface of the single crystal silicon substrate 82. The movable electrode supporting frame 10 is put on and fixed to this lower stationary electrode substrate 8 fabricated as stated above.

The upper stationary plate-like electrode 40 is fabricated in this embodiment as follows.

As shown in Fig. 14A, there is prepared a substrate 46 of a generally square in plan which comprises a substrate 44 of single crystal silicon of a generally square in plan and of a predetermined thickness, and insulation layers (for example, $SiO_2$ layers) 45T and 45B previously formed on the overall top and bottom surfaces of the substrate 44 respectively, and as shown in Fig. 14B, a patterning of the top insulation layer 45T of the substrate 46 and if necessary, a patterning of the bottom insulation layer 45B thereof are executed. The patterning of the top insulation layer 45T of the substrate 46 is to remove portions of the insulation layer 45T existing on portions 43A of the substrate 44 where the optical transmission paths 43 are to be formed and a portion of the insulation layer 45T existing on a portion 41A of the substrate 44 where the recess 41 is to be formed, as shown in Fig. 15. In addition, in case the electrostatically operated device of this embodiment will be used as an optical switch, the patterning of the bottom insulation layer 45B will be done, which removes a portion of the insulation layer 45B existing on the central portion (a generally square portion shown by dotted lines in Fig. 15) 42A of the substrate 44 where the through hole 42 through which the mirror can move is to be formed. Next, the single crystal silicon substrate 44 is etched by using the remaining insulation layers 45T and 45B resulting from the above patternings as masks respectively, thereby to form the recess 41 of a generally square in the central portion of the substrate 44 and four groove-like optical transmission paths 43 that extend from the centers of the four sides of the substrate 44 toward the center thereof, respectively, as shown in Fig. 14C. At the same time, the through hole 42 is formed in the center of the substrate 44. In such manner, the upper stationary plate-like electrode 40 is manufactured.

The movable electrode supporting frame 10 configured as stated above is put on and fixed to the top surface of the lower stationary electrode substrate 8 configured as stated above, and on the top surface of the movable electrode supporting frame 10 is put and fixed thereto the upper stationary plate-like electrode 40 configured as stated above by turning upside down, and then they are formed into one body. In practice, the upper stationary plate-like electrode 40 is fixed on the electrodes 83 on the top surfaces of the anchor portions 21A fixed to the movable electrode supporting frame 10. Thus, the electrostatically operated device DV constructed as shown in Fig. 12 is formed.

As is apparent from Fig. 12, the electrostatically operated device DV according to the present invention is characterized in that the movable plate-like electrode 2 is located at substantially the middle position of a distance between the top surface of the lower stationary electrode substrate 8 and the bottom surface of the recess 41 of the upper stationary plate-like electrode 40. Also, the electrostatically operated device DV according to the present invention is characterized in that when it is operated, either one of the operations is carried out, in which the movable plate-like electrode 2 is driven toward the upper stationary plate-like electrode 40 thereby to cause the electrode 2 to be attracted to the bottom surface of the recess 41 of the upper stationary plate-like electrode 40 (hereinafter, referred to simply as the bottom surface of the upper stationary plate-like electrode 40) or the movable plate-like electrode 2 is driven toward the lower stationary electrode substrate 8 thereby to cause the electrode 2 to be attracted to the top surface of the substrate 8.

As will be clear from the latter part of the description, it is preferred that a distance between the bottom surface of the movable plate-like electrode 2 and the top surface of the lower stationary electrode substrate 8 is set to a value substantially equal to a set value of a distance between the top surface of the movable plate-like electrode 2 and the bottom surface of the upper stationary plate-like electrode 40. In addition, it is preferred that the upper stationary plate-like electrode 40 is formed in large size so that its area can be substantially equal to that of the lower stationary electrode substrate 8. For this reason, in case the electrostatically operated device is applied to an optical switch, it is desirable that the through hole 42 in the center of the upper stationary plate-like electrode 40, through which a mirror can move, is formed to have a size as small as possible.

Further, the movable plate-like electrode 2 is fixed to the movable electrode supporting frame 10 in electrically insulated state because the two beams 21 integrally formed with the electrode 2 are fixed on the frame 10 in electrically insulated state, and on the bottom surface of the frame 10 is also formed the insulation layer (for example, $SiO_2$ layer) 10B. Accordingly, the united lower stationary electrode substrate 8 and movable electrode supporting frame 10 are electrically insulated from each other. In addition, on the bottom surface of the upper stationary plate-like electrode 40 united with the frame 10 is also formed the insulation layer (for example, $SiO_2$ layer) 45T. Accordingly, the movable plate-like electrode 2 and the upper stationary plate-like electrode 40 are electrically insulated from each other.

Figs. 16A to 16C are block diagrams for explaining the operation of a first embodiment of the electrostatically operated device according to the present invention. The positive electrode of a drive power supply E is connected through a first switch S1 to the upper stationary plate-like electrode 40 and also connected through a second switch S2 to the lower stationary electrode substrate 8, and the negative electrode of the drive power supply E is connected to the movable plate-like electrode 2. Further, in this example, the negative electrode of the drive power supply E is connected to ground that is shown by a block G.

In this first embodiment, there is illustrated a case that in the state shown in Fig. 16B that the movable plate-like electrode 2 is located at a first operation position in which it has been attracted to the upper stationary plate-like electrode 40, in case of electrostatically driving the movable plate-like electrode 2 by a distance X from the stationary plate-like electrode 40 to the stationary electrode substrate 8 for switching operation, or in the state shown in Fig. 16C that the movable plate-like electrode 2 is located at a second operation position in which it has been attracted to the lower stationary electrode substrate 8, in case of electrostatically driving the movable plate-like electrode 2 by a distance X from the stationary electrode substrate 8 to the stationary plate-like electrode 40 for switching operation, a distance or gap (electrode-to-electrode distance) A between the bottom surface of the upper stationary plate-like electrode 40 and the top surface of the lower stationary electrode substrate 8 is set to be equal to a distance X that the movable plate-like electrode 2 is to be electrostatically driven (namely, A=X). In reality, the driven distance X is shorter by the thickness of the movable plate-like electrode 2 than the electrode-to-electrode distance A. However, since the thickness of the electrode 2 is made very thin, it is considered that the driven distance X is substantially equal to the electrode-to-electrode distance A.

Accordingly, the construction of the first embodiment differs from that of the electrostatically operated device DV shown in Fig. 12 in at least the depth of the recess 41 formed in the upper stationary plate-like electrode 40 and in the thickness of the movable electrode supporting frame 10. For example, the depth of the recess 41 formed in the upper stationary plate-like electrode 40 is set to about 1/2 of the driven distance X, namely, about 0.5X, and the thickness of the movable electrode supporting frame 10 is also set to about 0.5X. Consequently, the thickness of space layers on the both sides of the movable plate-like electrode 2 becomes much thin as compared with the space layers shown in Fig. 12.

As shown in Fig. 16A, when the first and second switches S1 and S2 are both connected to the ground G, the upper stationary plate-like electrode 40, the lower stationary electrode substrate 8 and the movable plate-like electrode 2 are all connected to the ground G, and no drive voltage is applied to the electrode 40 as well as the substrate 8. As a result, the movable plate-like electrode 2 is held, in this embodiment, at substantially the middle position corresponding to about 1/2 of the electrode-to-electrode distance A between the top surface of the substrate 8 and the bottom surface of the electrode 40.

In order to drive the movable plate-like electrode 2 from the position shown in Fig. 16A to the first operation position, when the first switch S1 is connected to the drive power supply E and the second switch S2 is connected to the ground G, as shown in Fig. 16B, thereby to apply a drive voltage to the electrode 40, the movable plate-like electrode 2 is attracted to the bottom surface of the electrode 40 and hence driven to the first operation position. In such case, a distance that the movable plate-like electrode 2 is driven is equal to about 0.5X ($\approx$0.5A). On the other hand, in order to drive the movable plate-like electrode 2 from the position shown in Fig. 16A to the second operation position, when the first switch S1 is connected to the ground G and the second switch S2 is connected to the drive power supply E, as shown in Fig. 16C, thereby to apply the same drive voltage to the lower stationary electrode substrate 8, the movable plate-like electrode 2 is attracted to the top surface of the substrate 8 and hence driven to the second operation position. In such case, too, a distance that the movable plate-like electrode 2 is driven is equal to about 0.5X.

Since the electrode-to-electrode distance A is substantially equal to the driven distance X, the distance of about 0.5X between the top surface of the movable plate-like electrode 2 and the bottom surface of the upper stationary plate-like electrode 40 and the distance of about 0.5X between the bottom surface of the movable plate-like electrode 2 and the top surface of the lower stationary electrode substrate 8 are substantially equal to 0.5A, which is greater than 1/3 of the electrode-to-electrode distance A. As a result, in this first embodiment, the distance between the electrode 2 and the bottom surface of the electrode 40 and the distance between the electrode 2 and the top surface of the substrate 8 are set to a distance that is shorter than three times the pull-in displacement $\Delta x_{PULL-IN}$ corresponding to a distance that the electrode 2 is displaced when the drive voltage is set to the pull-in voltage $V_{PULL-IN}$. In other words, since the pull-in displacement $\Delta x_{PULL-IN}$ determined by the above-mentioned equation (2) corresponds to A/3, the driven distance of about 0.5X ($\approx$0.5A) of the movable plate-like electrode 2 corresponds to a displacement past the pull-in displacement $\Delta x_{PULL-IN}$. The pull-in voltage $V_{PULL-IN}$ at that time can be determined from the above-mentioned equation (3) as follows:

$$V_{PULL-IN} = \sqrt{\frac{8k(0.5)^3}{27\varepsilon_0 S}} \div \sqrt{\frac{8kg^3}{27\varepsilon_0 S}} = \sqrt{\frac{(0.5)^3}{g^3}} = \sqrt{0.5^3} \approx 0.35$$

Accordingly, if the pull-in voltage equal to 0.35 times the prior art pull-in voltage is applied to the lower stationary electrode substrate 8 or the upper stationary plate-like electrode 40, the movable plate-like electrode 2 is displaced past the pull-in displacement $\Delta x_{PULL-IN}$, which results in that the electrode 2 is electrostatically driven from the upper stationary plate-like electrode 40 to the lower stationary electrode substrate 8 by the distance X or from the substrate 8 to the electrode 40 by the distance X. That is, in this embodiment, it is possible to reduce the pull-in voltage to about 7/20≈1/3 of the prior art pull-in voltage. For instance, if the pull-in voltage in a prior art electrostatically operated device is 80 V, then in the electrostatically operated device according to the present invention that has the same shape, construction and structure as those of this prior art electrostatically operated device, the pull-in voltage becomes 80×7/20=28 V, and hence it is sufficient to generate the drive voltage of 30 V or so from the drive power supply E.

Here, it is the optimal or best design for maximizing the reduction rate of the drive voltage that the distance between the movable plate-like electrode 2 and the bottom surface of the upper stationary plate-like electrode 40 and the distance between the electrode 2 and the top surface of the lower stationary electrode substrate 8 are set to 0.5A that is 1/2 of the electrode-to-electrode distance A. However, if the distance between the electrode 2 and the bottom surface of the electrode 40 and the distance between the electrode 2 and the top surface of the substrate 8 are set to any other ratio except for 1:1, there is also obtained an effect that the drive voltage can be greatly reduced as compared with the prior art drive voltage, though there may be needed a drive voltage higher than that obtained when the ratio is 1:1.

Further, in case the electrostatically operated device of the first embodiment is applied to particularly an optical switch, it will be understood that it is preferred from the above-mentioned equation (3) of the pull-in voltage $V_{PULL-IN}$ to lessen sufficiently the area of the through hole 42 formed in the upper stationary plate-like electrode 40 for up and down movement of a micro mirror mounted on the top surface of the movable plate-like electrode 2, thereby to make the electrode area of the electrode 40 equal to that of the lower stationary electrode substrate 8 as far as possible.

Figs. 17A to 17C are block diagrams for explaining the operation of a second embodiment of the electrostatically operated device according to the present invention. The positive electrode of a drive power supply E is connected through a first switch S1 to the upper stationary plate-like electrode 40 and also connected through a second switch S2 to the lower stationary electrode substrate 8, and the negative electrode of the drive power supply E is connected to the movable plate-like electrode 2. Further, in this example, too, the negative electrode of the drive power supply E is connected to ground that is shown by a block G.

In this second embodiment, a feature resides in that in the state that a drive voltage lower than the pull-in voltage is applied between the upper stationary plate-like electrode 40 and the movable plate-like electrode 2 from the drive power supply E thereby to drive the electrode 2 toward the electrode 40 by a distance shorter than the pull-in displacement and to maintain the electrode 2 at that position (this position at which the electrode 2 is maintained is referred to as first operation position) as shown in Fig. 17B, or in the state that a drive voltage lower than the pull-in voltage is applied between the lower stationary electrode substrate 8 and the movable plate-like electrode 2 from the drive power supply E thereby to drive the electrode 2 toward the substrate 8 by a distance shorter than the pull-in displacement and to maintain the electrode 2 at that position (this position at which the electrode 2 is maintained is referred to as second operation position) as shown in Fig. 17C, it is arranged that the electrode 2 is electrostatically driven by a distance X from the first operation position that the electrode 2 is being displaced toward the electrode 40 to the second operation position that the electrode 2 is being displaced toward the substrate 8 for switching operation, or the electrode 2 is electrostatically driven by a distance X from the second operation position that the electrode 2 is being displaced toward the substrate 8 to the first operation position that the electrode 2 is being displaced toward the electrode 40 for switching operation, and a feature resides in that the electrode-to-electrode distance A between the bottom surface of the upper stationary plate-like electrode 40 and the top surface of the lower stationary electrode substrate 8 is set to a value greater than three times the distance X that the electrode 2 is to be electrostatically driven (namely, A>3X). Accordingly, it is deemed that the construction of the second embodiment is substantially the same as that of the electrostatically operated device DV shown in Fig. 12.

As shown in Fig. 17A, when the first and second switches S1 and S2 are both connected to the ground G, the upper stationary plate-like electrode 40, the lower stationary electrode substrate 8 and the movable plate-like electrode 2 are all connected to the ground G, and no drive voltage is applied to the electrode 40 as well as the substrate 8. As a result, the movable plate-like electrode 2 is maintained, in this embodiment, at substantially the middle position corresponding to about 1/2 of the electrode-to-electrode distance A between the top surface of the substrate 8 and the bottom surface of the electrode 40. Accordingly, the distance between the top surface of the electrode 2 and the bottom surface of the electrode 40 comes to 0.5A if the thickness of the electrode 2 is disregarded, and likewise, the distance between the bottom surface of the electrode 2 and the top surface of the substrate 8 comes to 0.5A. Further, for clarity of explanation, hereinafter, the thickness of the electrode 2 is disregarded.

In order to drive the movable plate-like electrode 2 from the position shown in Fig. 17A to the first operation position, when the first switch S1 is connected to the drive power supply E and the second switch S2 is connected to the ground G, as shown in Fig. 17B, thereby to apply a drive voltage lower than the pull-in voltage to the electrode 40, the electrode 2 is moved toward the electrode 40 by a distance shorter than the pull-in displacement and is held stopped at that position (the first operation position). In such case, a distance that the electrode 2 is driven is equal to 0.5X. Accordingly, the distance between the electrode 2 stopping at the first operation position and the bottom surface of the electrode 40 is longer than twice 0.5X.

On the other hand, in order to drive the movable plate-like electrode 2 from the position shown in Fig. 17A to the second operation position, when the first switch S1 is connected to the ground G and the second switch S2 is connected to the drive power supply E, as shown in Fig. 17C, thereby to apply the same drive voltage lower than the pull-in voltage to the lower stationary electrode substrate 8, the electrode 2 is moved toward the substrate 8 by a distance shorter than the pull-in displacement and is held stopped at that position (the second operation position). In such case, too, a distance that the electrode 2 is driven is equal to 0.5X. Accordingly, the distance between the electrode 2 stopping at the second operation position and the top surface of the substrate 8 is longer than twice 0.5X.

The pull-in displacement $\Delta X_{PULL-IN}$ determined by the above-mentioned equation (2) corresponds to 0.5A/3=A/6. As described above, since A>3X, A/6>3X/6 is formed, and since 3X/6=0.5X, A/6>0.5X is formed. Accordingly, the distance between the movable plate-like electrode 2 that is located at the position shown in Fig. 17A and the bottom surface of the upper stationary plate-like electrode 40 and the distance between the electrode 2 and the top surface of the lower stationary electrode substrate 8 are set, in the second embodiment, to a distance that is longer than three times the pull-in displacement $\Delta x_{PULL-IN}$ corresponding to a distance that the electrode 2 is displaced when the drive voltage is set to the pull-in voltage $V_{PULL-IN}$.

In other words, the driven distance of 0.5X of the electrode 2 corresponds to a displacement less than the pull-in displacement $\Delta x_{PULL-IN}$. As a result, the electrode 2 is surely maintained at the first operation position or the second operation position.

Accordingly, if a drive voltage equal to 0.35 times the prior art drive voltage lower than the pull-in voltage is applied to the lower stationary electrode substrate 8 or the upper stationary plate-like electrode 40 from the drive power supply E, the electrode 2 is displaced under the pull-in displacement $\Delta x_{PULL-IN}$, and is electrostatically driven to the first operation position or the second operation position that is away from the substrate 8 or the electrode 40 by a distance greater than twice the pull-in displacement $\Delta x_{PULL-IN}$. In addition, in case the movable plate-like electrode 2 is located at the first operation position, if a drive voltage lower than the pull-in voltage is applied to the lower stationary electrode substrate 8, the electrode 2 is driven to the second operation position, and likewise, in case the movable plate-like electrode 2 is located at the second operation position, if a drive voltage lower than the pull-in voltage is applied to the upper stationary plate-like electrode 40, the electrode 2 is driven to the first operation position.

Here, it is the optimal or best design for maximizing the reduction rate of the drive voltage that the distance between the movable plate-like electrode 2 and the bottom surface of the upper stationary plate-like electrode 40 and the distance between the electrode 2 and the top surface of the lower stationary electrode substrate 8 are set to 0.5A that is 1/2 of the electrode-to-electrode distance A. However, if the distance between the electrode 2 and the bottom surface of the electrode 40 and the distance between the electrode 2 and the top surface of the substrate 8 are set to any other ratio except for 1:1, there is also obtained an effect that the drive voltage can be greatly reduced as compared with the prior art drive voltage, though there may be needed a drive voltage higher than that obtained when the ratio is 1:1.

Further, in case the electrostatically operated device of the second embodiment is applied to particularly an optical switch, when the movable plate-like electrode 2 is driven to the first operation position toward the upper stationary plate-like electrode 40, the distance between the electrode 2 at the first operation position and the bottom surface of the electrode 40 is longer than twice 0.5X. Therefore, there is no possibility that a micro mirror mounted on the top surface of the electrode 2 comes into contact with the bottom surface of the electrode 40, and it is unnecessary to form the through hole 42 permitting the mirror to be moved therethrough in the electrode 40.

An example of design factors in the second embodiment shown in Fig. 17 is shown as follows:

Electrode area S of each of the upper stationary plate-like electrode 40 and the lower stationary electrode substrate 8:

$$S=1.09\times10^{-7}\ (m^2);$$

Distance A between the upper stationary plate-like electrode 40 and the lower stationary electrode substrate 8:

$$A=1.80\times10^{-4}\ (m);$$

Distance between the movable plate-like electrode 2 and the upper stationary plate-like electrode 40 when no voltage is applied:

A/2

Distance between the movable plate-like electrode 2 and the lower stationary electrode substrate 8 when no voltage is applied:

A/2

Spring constant k of the beams 21:

$$k=5.04\times10^{-3}\ (N/m).$$

When an electrostatically operated device having the above factors has been manufactured, the pull-in voltage $V_{PULL-IN}$ has become 33.1 V. Therefore, a voltage of 30 V has been applied between the movable plate-like electrode 2 and the upper stationary plate-like electrode 40 or between the movable plate-like electrode 2 and the lower stationary electrode substrate 8 of this electrostatically operated device to drive the movable plate-like electrode 2, and the result has been obtained that the displacement of the electrode 2 has been less than the pull-in displacement $\Delta x_{PULL-IN}$ ($A/3 = 6\times10^{-5}$ m). As a result, the electrode 2 has certainly remained stopped at the first operation position or the second operation position that is away from the surface of the electrode 40 or the substrate 8, and hence high reliable and good operation has been achieved.

On the contrary, in the electrostatically operated device DV shown in Fig. 12, the upper stationary plate-like electrode 40 is removed therefrom, and the distance between the movable plate-like electrode 2 and the lower stationary electrode substrate 8 when no drive voltage is applied is denoted by A, the electrode area of each of the movable plate-like electrode 2 and the lower stationary electrode substrate 8 is denoted by S, and A and S are set to the values described above, namely, $A=1.80\times10^{-4}$ (m) and $S=1.09\times10^{-7}$ (m$^2$). In addition, the spring constant k of the beams 21 is also set to the value described above, namely, $k=5.04\times10^{-3}$ (N/m). As a result, the pull-in voltage $V_{PULL-IN}$ becomes 94.6 V. Therefore, in this case, a drive voltage of 90 V or so is applied between the lower stationary electrode substrate 8 and the movable plate-like electrode 2 of this electrostatically operated device to drive the electrode 2, thereby to cause the electrode 2 to be displaced less than the pull-in displacement.

On the other hand, in case of the second embodiment, as discussed above, the drive voltage is 30 V, and there is obtained a remarkable advantage that the drive voltage can be reduced to about 1/3 of the aforesaid device.

Moreover, in case of the second embodiment, since the movable plate-like electrode 2 is displaced only less than the pull-in displacement, the electrode remains stopped at the first operation position or the second operation position that is away from the upper stationary plate-like electrode 40 or the lower stationary electrode substrate 8 by a distance more than twice the pull-in displacement. Accordingly, unlike the first embodiment, the movable plate-like electrode 2 does not come into contact with the stationary electrode substrate 8 or the upper stationary plate-like electrode 40, and hence a phenomenon does not occur that the electrode 2 is temporarily attracted to the electrode 40 or the substrate 8 by van der Waals' force. Thus, in the electrostatically operated device of the second embodiment, though the drive voltage becomes higher than that of the electrostatically operated device of the first embodiment (the pull-in voltage of the second embodiment becomes about 5.2 times that of the first embodiment), a temporary attraction of the electrode 2 to the electrode 40 or the substrate 8 by van der Waals' force does not occur. Therefore, it is possible to switch the path of an optical signal always in an instant, and there is obtained an advantage that the reliability of switching operation becomes further increased.

In the aforesaid embodiments, there has been described a case that the present invention is applied to an optical switch manufactured by use of micromachining technology. However, it is needless to say that the present invention can be also applied to various types of electrostatically operated devices such as VOA (Variable Optical Attenuator) manufactured by use of micromachining technology in addition to the optical switch, and the same function and effect can be obtained therefrom.

Further, it goes without saying that the shape and size of the movable plate-like electrode, lower stationary electrode substrate or upper stationary plate-like electrode, and the number, shape and size of the beams, etc., are not limited to the illustrated examples, and can be modified, altered or changed variously if the need arises.

As is clear from the foregoing, in accordance with the present invention, in an electrostatically operated device manufactured by use of micromachining technology, it is arranged that on the upper side and the lower side of a movable plate-like electrode are disposed an upper stationary plate-like electrode and a lower stationary electrode substrate opposed to each other, each being substantially in parallel with the movable plate-like electrode, with a predetermined gap between the movable plate-like electrode and the upper stationary plate-like electrode as well as between the movable plate-like electrode and the lower stationary electrode substrate, and that a drive voltage is applied between the upper stationary plate-like electrode and the movable plate-like electrode or between the lower stationary electrode substrate and the movable plate-like electrode, thereby to drive the movable plate-like electrode. Accordingly, the movable plate-like electrode is driven by the attraction produced from the upper stationary plate-like electrode or the lower stationary electrode substrate. As a result, there is obtained a remarkable advantage that the magnitude of the drive voltage can be reduced to about 0.35 times that of the prior art electrostatically operated device, namely, about 1/3 of the drive voltage of the prior art electrostatically operated device at the maximum.

While the present invention has been described with regard to the preferred embodiments shown by way of example, it will be apparent to those skilled in the art that various modifications, alterations, changes, and/or minor improvements of the embodiments described above can be made without departing from the spirit and the scope of the present invention. Accordingly, it should be understood that the present invention is not limited to the illustrated embodiments, and is intended to encompass all such modifications, alterations, changes, and/or minor improvements falling within the scope of the invention defined by the appended claims.

**Claims**

1.  An electrostatically operated device manufactured by use of micromachining technology comprising:

    a stationary electrode substrate;
    a movable plate-like electrode disposed substantially in parallel with said stationary electrode substrate with a predetermined gap therebetween;
    a second stationary plate-like electrode disposed substantially in parallel with said movable plate-like electrode with a predetermined gap therebetween; and
    means for supporting said movable plate-like electrode to be movable between the second stationary plate-like electrode and the stationary electrode substrate,

    wherein the movable plate-like electrode is maintained at a position that is away by a first predetermined distance from the stationary electrode substrate and by a second predetermined distance from the second stationary plate-like electrode when any drive voltage is not applied between the second stationary plate-like electrode and the movable plate-like electrode as well as between the stationary electrode substrate and the movable plate-like electrode, and
    the movable plate-like electrode being electrostatically driven toward the second stationary plate-like electrode by applying a drive voltage between the second stationary plate-like electrode and the movable plate-like electrode, or the movable plate-like electrode being electrostatically driven toward the stationary electrode substrate by applying a drive voltage between the stationary electrode substrate and the movable plate-like electrode.

2.  The electrostatically operated device as set forth in claim 1, wherein a drive voltage applied between the second stationary plate-like electrode and the movable plate-like electrode, or a drive voltage applied between the stationary electrode substrate and the movable plate-like electrode is a voltage more than the pull-in voltage, and the movable plate-like electrode is maintained in a state that it is attracted to the second stationary plate-like electrode, or in a state that it is attracted to the stationary electrode substrate.

3.  The electrostatically operated device as set forth in claim 1, wherein a drive voltage applied between the second stationary plate-like electrode and the movable plate-like electrode, or a drive voltage applied between the stationary electrode substrate and the movable plate-like electrode is a voltage less than the pull-in voltage, and the movable plate-like electrode is maintained in a state that it is displaced less than the pull-in displacement toward the second stationary plate-like electrode, or in a state that it is displaced less than the pull-in displacement toward the stationary electrode substrate.

4.  The electrostatically operated device as set forth in claim 2 or 3, wherein the movable plate-like electrode is maintained at a position that is away by the same distance from the stationary electrode substrate and from the second stationary plate-like electrode when any drive voltage is not applied between the second stationary plate-like electrode and the movable plate-like electrode as well as between the stationary electrode substrate and the movable plate-like electrode.

5.  The electrostatically operated device as set forth in claim 3, wherein the electrode-to-electrode distance between the second stationary plate-like electrode and the stationary electrode substrate is set to a value that is greater than three times the sum of a distance that the movable plate-like electrode is moved toward the second stationary plate-like electrode and a distance that the movable plate-like electrode is moved toward the stationary electrode substrate when the movable plate-like electrode is electrostatically driven by application of a voltage less than the pull-in voltage.

6. The electrostatically operated device as set forth in any one of claims 1 to 3, further including:

a first switch for turning on or off a drive voltage applied between the second stationary plate-like electrode and the movable plate-like electrode; and
a second switch for turning on or off a drive voltage applied between the stationary electrode substrate and the movable plate-like electrode, and wherein
either one of a state that no drive voltage is applied, a state that a drive voltage is applied between the second stationary plate-like electrode and the movable plate-like electrode, or a state that a drive voltage is applied between the stationary electrode substrate and the movable plate-like electrode is selected by on/off operations of the first and second switches.

SW1

85T  21  2  3  21  84

10

2  4  83  83  5  2

L

6  12

## FIG. 1

4  83  21  L  3  2  21  83  5

21A  21A
11  11
10  10
10B  10B
8
85T  12  85B

SW1

## FIG. 2

FIG. 3A

FIG. 3B

FIG. 3C

FIG. 3D

FIG. 3E

FIG. 3F

FIG. 3G

FIG. 3H

FIG. 4

FIG. 5

FIG. 6

FIG. 7

FIG. 8

FIG. 9

FIG. 10

FIG. 11

## FIG. 12

## FIG. 13A

## FIG. 13B

# FIG. 14A

# FIG. 14B

# FIG. 14C

# FIG. 15

FIG. 16A

40

UPPER STATIONARY
ELECTRODE

A
2

A/2
A/2

X

LOWER STATIONARY
ELECTRODE

8

S1

G

E

G

DRIVE POWER
SUPPLY

G

S2

FIG. 16B

40

UPPER STATIONARY
ELECTRODE

A
2

X

LOWER STATIONARY
ELECTRODE

8

S1

G

E

G

DRIVE POWER
SUPPLY

G

S2

FIG. 16C

40

UPPER STATIONARY
ELECTRODE

A
2

X

LOWER STATIONARY
ELECTRODE

8

S1

G

E

G

DRIVE POWER
SUPPLY

G

S2

FIG. 17A

UPPER STATIONARY ELECTRODE

40

2

0.5X
0.5X

X

A

A/2

A/2

G

LOWER STATIONARY ELECTRODE

8

S1

G

E

DRIVE POWER SUPPLY

G

S2

FIG. 17B

UPPER STATIONARY ELECTRODE

40

2

X

A

A/2

A/2

G

LOWER STATIONARY ELECTRODE

8

S1

G

E

DRIVE POWER SUPPLY

G

S2

FIG. 17C

UPPER STATIONARY ELECTRODE

40

2

X

A

A/2

A/2

G

LOWER STATIONARY ELECTRODE

8

S1

G

E

DRIVE POWER SUPPLY

G

S2